# EUROPEAN PATENT SPECIFICATION

(11) **EP 4 338 096 B1**
(45) Date of publication and mention of the grant of the patent: **02.12.2026**
(21) Application number: 22841253.2
(22) Date of filing: 07.07.2022
(51) Int. Cl.: G06K 19/077

(54) **CHIP MODULE AND METHOD OF FORMING SAME**
CHIPMODUL UND VERFAHREN ZU SEINER HERSTELLUNG
MODULE DE PUCE ET SON PROCÉDÉ DE FORMATION

(30) Priority: 16.07.2021 US 202163222560 P
(43) Date of publication of application: 20.03.2024
(73) Proprietor: ACT Identity Technology Limited, Kwai Chung, New Territories Hong Kong (HK)
(72) Inventor: CHEN, Gang, Hong Kong (CN)
(74) Representative: Marks & Clerk LLP
(86) International application number: PCT/CN2022/104250
(87) International publication number: WO 2023/284616

(56) References cited:
- WO-A1-2021/116048
- CN-A- 102 426 657
- CN-A- 108 292 373
- CN-A- 110 619 379
- CN-U- 206 757 681
- US-B1- 6 607 135

## Description

### Field of the Invention

This invention relates to a chip module, such as an integrated-circuit (IC) chip module, a chip module card inlay with such a chip module, a method of forming such a chip module, and a method of forming such a chip module card inlay.

### Background of the Invention

Chip module card inlays are frequently used for the production of smart cards, e.g. credit cards, identity cards, etc. Such cards are used frequently, and may be subjected to warping and bending when carried around by the users or in use. Such warping and bending of the cards may adversely affect the structural integrity and proper functioning of the cards. Furthermore, conventional chip modules in the smart card industry do not provide a flat and uniform top surface, which adversely affect the manufacturing process of chip module card inlays and smart cards. In particular, chip modules are conventionally of a two-level stepped structure or formed with an uneven top housing, as in the chip on board method.

WO 2021116048A1 discloses a circuit for a chip card module comprising a multilayer structure. The multilayer structure comprises an insulating substrate and a first conductive layer supported by one side of the insulating substrate. The first conductive layer is intended to be electrically connected to an electronic chip, with electrical wires wire- bonded to the first conductive layer. The first conductive layer is a copper-based layer having a Vicker hardness greater than or equal to 100 VHN.

It is thus an object of the present invention to provide a chip module, a chip module card inlay, a method of forming a chip module, and a method of forming a chip module card inlay in which the aforesaid shortcoming is mitigated, or at least to provide a useful alternative to the trade and public.

### Summary of the Invention

According to a first aspect of the present invention, there is provided a chip module for a smart card including an integrated-circuit (IC) chip, a first substrate layer made at least partly of a flexible material and with a first hole, a second substrate layer made at least partly of an adhesive material and with a second hole, a third substrate layer made at least partly of an electrically conductive material, a fourth substrate layer made at least partly of an adhesive material and with a third hole (30), and a fifth substrate layer with a fourth hole, wherein said second substrate layer is sandwiched between and fixedly engaged with said first substrate layer and said third substrate layer, wherein said first hole of said first substrate layer and said second hole of said second substrate layer are aligned with each other to form a first cavity, and wherein at least a first part of said IC chip is received within said first cavity, characterized in that said chip module is in the shape of a prism, a cylinder, or an elliptical cylinder.

According to a second aspect of the present invention, there is provided a chip module card inlay including at least one chip module, said chip module including an integrated-circuit (IC) chip, a first substrate layer made at least partly of a flexible material and with a first hole, a second substrate layer made at least partly of an adhesive material and with a second hole, a third substrate layer made at least partly of an electrically conductive material, a fourth substrate layer made at least partly of an adhesive material and with a third hole, and a fifth substrate layer with a fourth hole, wherein said second substrate layer is sandwiched between and fixedly engaged with said first substrate layer and said third substrate layer, wherein said first hole of said first substrate layer and said second hole of said second substrate layer are aligned with each other to form a first cavity, and wherein at least a first part of said IC chip is received within said first cavity, characterized in that said chip module is in the shape of a prism, a cylinder, or an elliptical cylinder.

According to a third aspect of the present invention, there is provided a method of forming a chip module for a smart card including providing a first substrate layer made at least partly of a flexible material and with a plurality of first holes, providing a second substrate layer made at least partly of an adhesive material and with a plurality of second holes, providing a third substrate layer made at least partly of an electrically conductive material, aligning said first holes of said first substrate layer with said second holes of said second substrate layer to form a plurality of first cavities, sandwiching said second substrate layer between said first substrate layer and said third substrate layer, fixedly engaging said first substrate layer, said second substrate layer and said third substrate layer to form a first layered structure, fixedly engaging at least a first part of an integrated-circuit (IC) chip within one of said first cavities of said first layered structure, providing a fourth substrate layer made at least partly of an adhesive material and with a plurality of third holes and a fifth substrate layer with a plurality of fourth holes, fixedly engaging said fourth adhesive substrate layer and said fifth substrate layer with said first layered structure to form a second layered structure, and cutting out at least one chip module from said second layered structure fixedly engaged with said IC chip, characterized in that said chip module is in the shape of a prism, a cylinder, or an elliptical cylinder.

According to a fourth aspect of the present invention, there is provided a method of forming a chip module card inlay including forming at least one chip module including providing a first substrate layer made at least partly of a flexible material and with a plurality of first holes, providing a second substrate layer made at least partly of an adhesive material and with a plurality of second holes, providing a third substrate layer made at least partly of an electrically conductive material, aligning said first holes of said first substrate layer with said second holes of said second substrate layer to form a plurality of first cavities, sandwiching said second substrate layer between said first substrate layer and said third substrate layer, fixedly engaging said first substrate layer, said second substrate layer and said third substrate layer to form a first layered structure, fixedly engaging at least a first part of an integrated-circuit (IC) chip within one of said first cavities of said first layered structure, providing a fourth substrate layer made at least partly of an adhesive material and with a plurality of third holes and a fifth substrate layer with a plurality of fourth holes, fixedly engaging said fourth adhesive substrate layer and said fifth substrate layer with said first layered structure to form a second layered structure, and cutting out at least one chip module from said second layered structure fixedly engaged with said IC chip, characterized in that said chip module is in the shape of a prism, a cylinder, or an elliptical cylinder.

### Brief Description of the Drawings

Embodiments of the present invention will now be described, by way of examples only, with reference to the accompanying drawings, in which:
Fig. 1 is a perspective view of a length of chip housing carrier formed of five substrate layers suitable for forming a chip module and a chip module card inlay according to an embodiment of the present invention;
Fig. 2 is a disassembled perspective view of the length of chip housing carrier of Fig. 1;
Fig. 3 is a top view of the five substrate layers forming the length of chip housing carrier of Fig. 1;
Fig. 4 is a front view of a flipped integrated-circuit (IC) chip;
Fig. 5 shows steps of forming chip modules from the length of chip housing carrier of Fig. 1 and the flipped IC chip of Fig. 4;
Figs. 6 to 9 shows steps of forming a chip module card inlay from the chip module formed in Fig. 5; and
Fig. 10 is a sectional view of a chip module card inlay according to an embodiment of the present invention.

### Description of the Embodiments

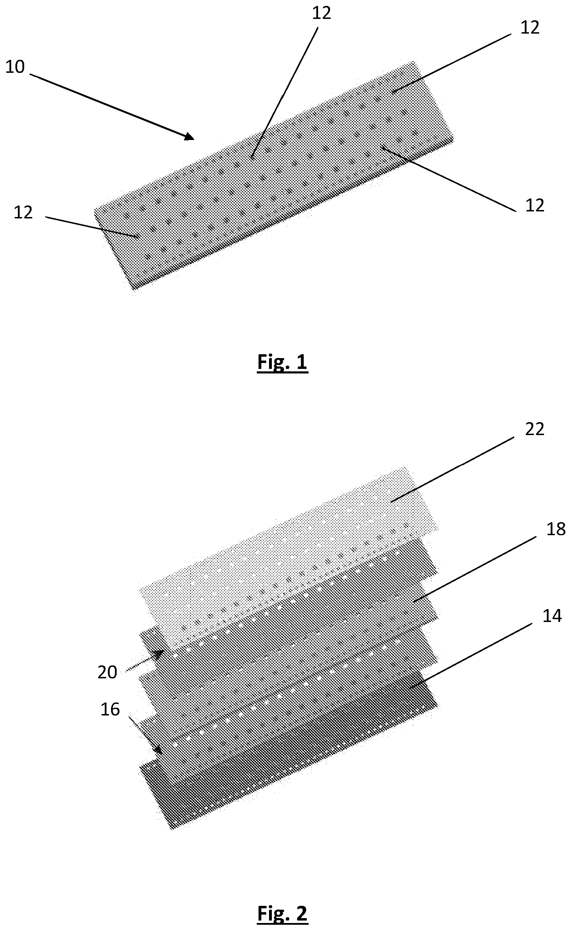

Fig. 1 shows a length of chip housing carrier 10 formed of five substrate layers for forming a chip module and a chip module card inlay according to an embodiment of the present invention. The chip housing carrier 10 is elongate in shape and may be wound around itself in a reel form, and then unwound for subsequent steps for forming the chip module and chip module card inlay. Along the chip housing carrier 10 are formed a number of cavities 12. The cavities 12 may be of a square, rectangular, or circular transverse cross sectional shape. As shown as an example in Fig. 1, the cavities 12 are arranged in three rows, although it should be understood that the chip housing carrier 10 may be formed with other numbers of rows of cavities 12.

Fig. 2 is a disassembled perspective view of the length of chip housing carrier 10 shown in Fig. 1. This chip housing carrier 10 according to this embodiment is made of five substrate layers 14, 16, 18, 20, 22 stacked one on top of the other. It should be understood that, according to the present invention, the chip housing carrier 10 may be formed of a different number of substrate layers, e.g. only of the substrate layers 14, 16, 18.

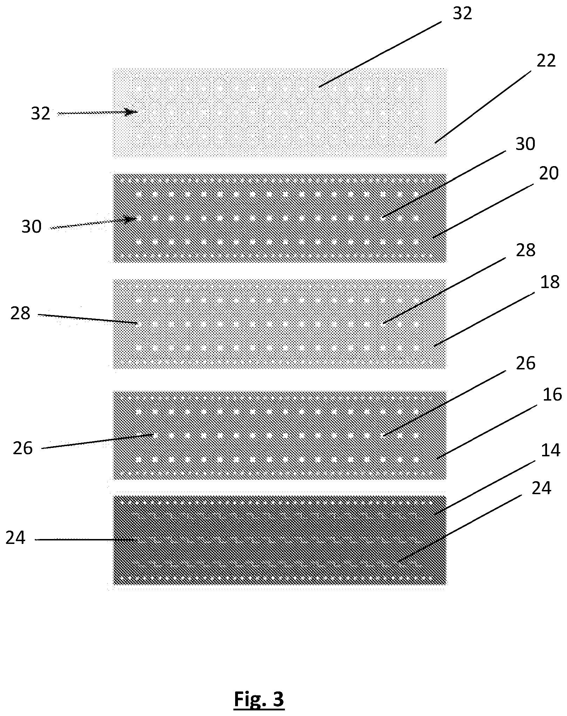

The five substrate layers 14, 16, 18, 20 and 22 are shown separately in Fig. 3. The substrate layer 14 is made of copper (or other electrically conductive material(s)). Three rows of slits 24 are formed along the length of the substrate layer 14. On top of the substrate layer 14 is the substrate layer 16 with three rows of holes 26 along its length. The substrate layer 16 is made of an adhesive material. On top of the substrate layer 16 is the substrate layer 18 with three rows of holes 28 along its length. The substrate layer 18 is flexible, e.g. being made of a flexible material, such as one or more of polyimide (PI), polyethylene terephthalate (PET), and a glass-reinforced epoxy laminate material (such as "FR-4", which is a composite material composed of woven fiberglass cloth with an epoxy resin binder that is flame resistant).

On top of the substrate layer 18 is the substrate layer 20 with three rows of holes 30 along its length. The substrate layer 20 is made of an adhesive material. On top of the substrate layer 20 is the substrate layer 22 with three rows of holes 32. The substrate layer 22 is made of or electro-plated with one or more electrically conductive materials, e.g. copper and nickel.

The holes 26, 28, 30, 32 of the respective substrate layers 16, 18, 20, 22 are of the same size and shape, and are arranged such that when the substrate layers 16, 18, 20, 22 are duly assembled and stacked one on top of another, their respective holes 26, 28, 30, 32 are aligned with one another such that they collectively form a number of cavities 12 extending through the substrate layer 16 to the substrate layer 22. The substrate layer 16 are positioned under and in contact with the substrate layer 14 such that a respective slit 24 is positioned below each cavity 12 formed by a row of the holes 26, 28, 30, 32 aligned with one another.

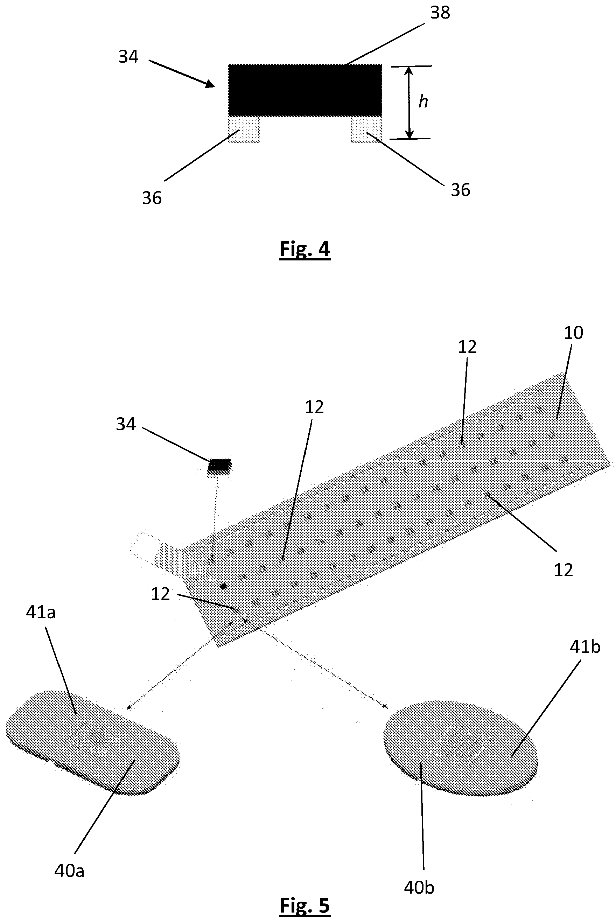

Fig. 4 shows an integrated-circuit (IC) chip 34. The IC chip 34 may be a contactless chip or other types of chip. In electronics manufacturing, integrated circuit (IC) packaging is the final stage of semiconductor device fabrication, in which the block of semiconductor material is encapsulated in a supporting case (also known as a "package") that prevents physical damage and corrosion. A common plastic used for making the package is epoxy-cresol-novolak (also called "epoxy-cresol-novolac"). In the IC chip 34, two electrically conductive legs 36 are shown as extending and leading from a package 38 of the IC chip 34.

Turning to Fig. 5, such shows a length of chip housing carrier 10 with a number of cavities 12 formed by the alignment of the holes 26, 28, 30, 32 of the respective substrate layers 16, 18, 20, 22 with the substrate layer 14 forming a bottom. The substrate layers 14, 16, 18, 20, 22 are then laminated to fixedly engaged with one another to form the chip housing carrier 10, which is of a layered-structure. The IC chip 34 is positioned within one of the cavities 12 such that the IC chip 34 is fully received within the cavity 12 with the legs 36 contacting the substrate layer 14 as to establish electrical and physical connection between the legs 36 (and thus the IC chip 34) with the substrate layer 14. The depth of the cavity 12 formed by the alignment of the holes 26, 28, 30, 32 of the substrate layers 16, 18, 20, 22 is no shorter than the total height h of the IC chip 34, with a part of the IC chip 34 received within the cavity formed by the holes 26, 28 and another part of the IC chip 34 received within the cavity formed by the holes 30, 32.

When the IC chip 34 is received within the cavity 12 (and with its legs 36 physically and electrically connected with the substrate layer 14), an adhesive (glue) is filled into any space within the cavity 12 not occupied by the IC chip 34, so as to enhance the fixed engagement of the IC chip 34 within the cavity 12 and with the chip housing carrier 10.

When the IC chips 34 are fixedly engaged with and received within the cavities 12 of the chip housing carrier 10, a plurality of chip modules 40a, 40b are cut out from the chip housing carrier 10, e.g. by die-cutting. Each of the chip modules 40a, 40b comprises an IC chip 34 fixedly received within and engaged with the substrate layers 14, 16, 18, 20, 22, with the substrate layer 14 fixedly engaged with the legs 36 of the IC chip 34. The chip modules 40a, 40b differ with each other in their respective shape, in that the chip module 40a is in the shape of a generally rectangular prism, and the chip module 40b is in the shape of a generally elliptical cylinder. Generally speaking, the chip modules 40a, 40b according to the present invention may be in the shape of a prism, a cylinder, or an elliptical cylinder, more particularly, a right prism, a right cylinder, or a right elliptical cylinder, all of a relatively short thickness/height. The two opposite major surfaces of the chip module 40a (of which only one of which, 41a, is shown in Fig. 5) are planar, of the same shape and parallel with each other. Similarly, the two opposite major surfaces of the chip module 40b (of which only one of which, 41b, is shown in Fig. 5) are planar, of the same shape and parallel with each other. Thus, the chip modules 40a, 40b are not in of a two-level stepped structure or formed with an uneven top housing, as in the case of conventional chip modules.

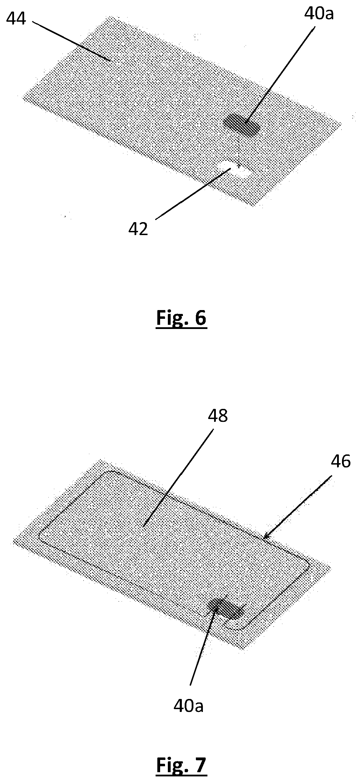

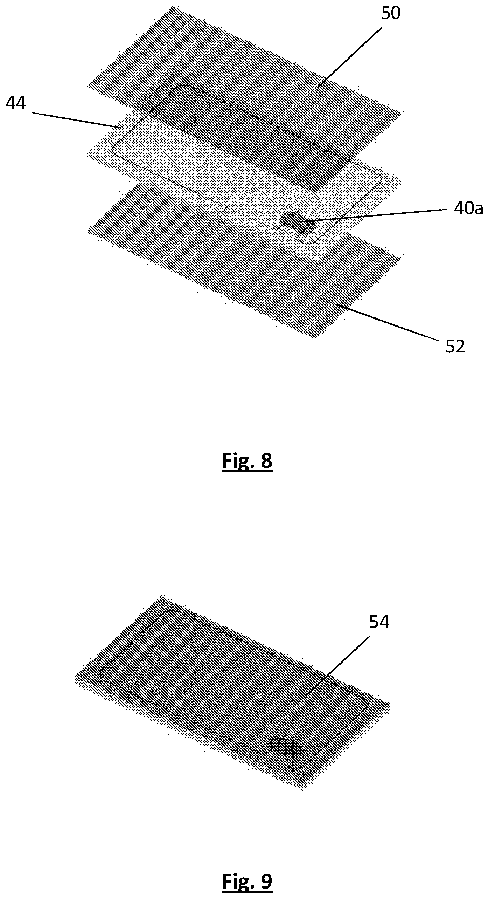

Figs. 6 to 9 shows steps of forming a chip module card inlay, using the chip module 40a as an example.

As shown in Fig. 6, the chip module 40a is positioned within a hole 42 of a substrate layer 44, which may be made of a plastic material, such as polycarbonate (PC), polyvinyl chloride (PVC), or polyethylene terephthalate glycol (PETG). In the case of the conventional two-level stepped structured chip modules, at least two such substrate layers (also called "compensation layers") are required, to cater for the different shapes of the two levels. On the other hand, as the chip modules according to the present invention may be in the shape of a prism, a cylinder, or an elliptical cylinder, more particularly, a right prism, a right cylinder, or a right elliptical cylinder, only one compensation layer is required. This facilitates the production of the chip module card inlays (to be discussed below) and subsequently the smart cards.

As further shown in Fig. 7, an electrically conductive wire 46 (e.g. made of copper) is embedded on a major surface 48 of the substrate layer 44. The wire 46 may be embedded on the major surface 48 of the substrate layer 44 for several rounds, e.g. to form an antenna. Two free ends of the wire 46 are bonded with the chip module 40a, e.g. by thermo-bonding.

The substrate layer 44 is sandwiched between two protective substrate layers 50, 52. The two substrate layers 50, 52 may also be made of PC, PVC or PETG. The substrate layers 44, 50, 52 thus stacked together with one another are then laminated so as to fixedly engage the substrate layers 44, 50, 52 to form a chip module card inlay 54, which is in a layered-structure.

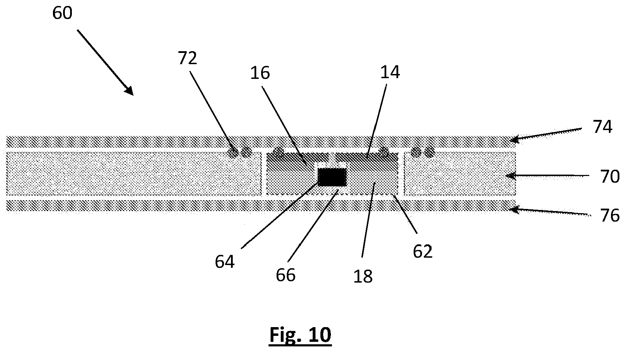

Fig. 10 shows a sectional view of a chip module card inlay 60 with a chip module 62. The chip module 62 has an IC chip 64 received within a cavity 66 formed of alignment of the holes 26, 28 of the respective substrate layers 16, 18. The legs 36 of the IC chip 64 are connected physically and electrically with the substrate layer 14 on top of the substrate layer 16. The substrate layer 16 is thus sandwiched between and fixedly engaged with the substrate layers 14, 18.

The chip module 62 is received within a hole 68 of an inner substrate layer 70, and is electrically connected (e.g. by bonding) to an antenna formed of an electrically conductive wire 72 (which may be made of copper). The inner substrate layer 70 is sandwiched between two outer substrate layers 74, 76. The substrate layers 70, 74, 76 are laminated and thus fixedly engaged with one another to form the chip module card inlay 60 in a layered structure. The depth of the cavity 66 formed by the alignment of the holes 26, 28 of the substrate layers 16, 18 is no shorter than the total height of the IC chip 64.

It should be understood that the above only illustrates and describes examples whereby the present invention may be carried out, and that modifications and/or alterations may be made thereto without departing from the scope of the claims.

It should also be understood that certain features of the invention, which are, for clarity, described in the context of separate embodiments, may also be provided in combination in a single embodiment. Conversely, various features of the invention which are, for brevity, described in the context of a single embodiment, may also be provided separately or in any suitable sub-combination without departing from the scope of the appended claims.

## Claims

1. A chip module (40a, 40b, 62) for a smart card including:
an integrated-circuit (IC) chip (34, 64),
a first substrate layer (18) made at least partly of a flexible material and with a first hole (28),
a second substrate layer (16) made at least partly of an adhesive material and with a second hole (26),
a third substrate layer (14) made at least partly of an electrically conductive material,
a fourth substrate layer (20) made at least partly of an adhesive material and with a third hole (30), and
a fifth substrate layer (22) with a fourth hole (32),
wherein said second substrate layer is sandwiched between and fixedly engaged with said first substrate layer and said third substrate layer,
wherein said first hole of said first substrate layer and said second hole of said second substrate layer are aligned with each other to form a first cavity (12, 66), and
wherein at least a first part of said IC chip is received within said first cavity,
**characterized in that** said chip module is in the shape of a prism, a cylinder, or an elliptical cylinder.

2. The chip module of Claim 1, wherein said third substrate layer is made at least partly of copper.

3. The chip module of Claim 1 or 2, wherein said third substrate layer includes at least one slit (24) engaged with a leg (36) of said IC chip to electrically connect said IC chip with said third substrate layer.

4. The chip module of any of the preceding claims, wherein said first hole and said second hole are of the substantially the same size and shape.

5. The chip module of any of the preceding claims, wherein said first substrate layer is made of polyimide (PI), polyethylene terephthalate (PET), and/or a glass-reinforced epoxy laminate material.

6. The chip module of Claim 1, wherein said third hole and said fourth hole are aligned with each other to form a second cavity, and wherein at least a second part of said IC chip is received within said second cavity.

7. The chip module of Claim 6, wherein said third hole and said fourth hole are of the substantially the same size and shape.

8. The chip module of any one of the preceding claims, wherein said fifth substrate layer is made of or electro-plated with an electrically conductive material.

9. The chip module of any one of the preceding claims, wherein two opposite major surfaces of said chip module are planar, of the same shape and parallel to each other.

10. A chip module card inlay (54) including at least one chip module according to any one of Claims 1 to 9.

11. The chip module card inlay of Claim 10, wherein said chip module is received within a fifth hole (68) of a sixth substrate layer (70).

12. The chip module card inlay of Claim 11, wherein said sixth substrate layer is sandwiched between and fixedly engaged with a seventh substrate layer (74) and an eighth substrate layer (76).

13. The chip module card inlay of any one of Claims 10 to 12, wherein said chip module is electrically connected with at least one conductive wire (72).

14. A method of forming a chip module (40a, 40b, 62) for a smart card including:
providing a first substrate layer (18) made at least partly of a flexible material and with a plurality of first holes (28),
providing a second substrate layer (16) made at least partly of an adhesive material and with a plurality of second holes (26),
providing a third substrate layer (14) made at least partly of an electrically conductive material,
aligning said first holes of said first substrate layer with said second holes of said second substrate layer to form a plurality of first cavities (12, 66),
sandwiching said second substrate layer between said first substrate layer and said third substrate layer,
fixedly engaging said first substrate layer, said second substrate layer and said third substrate layer to form a first layered structure (54),
fixedly engaging at least a first part of an integrated-circuit (IC) chip (34, 64) within one of said first cavities of said first layered structure,
providing a fourth substrate layer (20) made at least partly of an adhesive material and with a plurality of third holes (30) and a fifth substrate layer (22) with a plurality of fourth holes (32),
fixedly engaging said fourth adhesive substrate layer and said fifth substrate layer with said first layered structure to form a second layered structure, and
cutting out at least one chip module from said second layered structure fixedly engaged with said IC chip,
**characterized in that** said chip module is in the shape of a prism, a cylinder, or an elliptical cylinder.

15. The method of Claim 14, wherein said third substrate layer is made at least partly of copper.

16. The method of Claim 14 or 15, including engaging a leg (36) of said IC chip with at least one slit (24) of said third substrate layer to electrically connect said IC chip with said third substrate layer.

17. The method of any one of Claims 14 to 16, wherein said first holes and said second holes are of the substantially the same size and shape.

18. The method of any one of Claims 14 to 17, further including filling at least a part of a space between said first part of said IC chip and said first cavity with an adhesive.

19. The method of any one of Claims 14 to 18, wherein said first substrate layer is made of polyimide (PI), polyethylene terephthalate (PET), and/or a glass-reinforced epoxy laminate material.

20. The method of Claim 19, further including aligning said third holes of said fourth adhesive substrate layer with said fourth holes of said fifth substrate layer to form a plurality of second cavities, and positioning at least a second part of said IC chip within one of said second cavities.

21. The method of Claim 20, wherein said third holes and said fourth holes are of the substantially the same size and shape.

22. The method of any one of Claims 20 to 21 , wherein said fifth substrate layer is made of or electro-plated with an electrically conductive material.

23. The method of any one of Claims 14 to 22, wherein two opposite major surfaces of said chip module are planar, of the same shape and parallel to each other.

24. A method of forming a chip module card inlay (60) including forming at least one chip module according to a method according to any one of Claims 14 to 23.

25. The method of Claim 24, including positioning said chip module within a fifth hole (68) of a sixth substrate layer (70).

26. The method of Claim 25, including sandwiching said sixth substrate layer between a seventh substrate layer (74) and an eighth substrate layer (76), and fixedly engaging said sixth substrate layer, said seventh substrate layer and said eighth substrate layer with one another.

27. The method of any one of Claims 24 to 26, including electrically connecting said chip module with at least one conductive wire (72).

## Patentansprüche

1. Chipmodul (40a, 40b, 62) für eine Smartcard, einschließend
einen Chip mit integriertem Schaltkreis (IC-Chip) (34, 64),
eine erste Substratschicht (18), die zumindest teilweise aus einem flexiblen Material besteht und ein erstes Loch (28) aufweist,
eine zweite Substratschicht (16), die zumindest teilweise aus einem Klebematerial besteht und ein zweites Loch (26) aufweist,
eine dritte Substratschicht (14), die zumindest teilweise aus einem elektrisch leitfähigen Material besteht,
eine vierte Substratschicht (20), die zumindest teilweise aus einem Klebematerial besteht und ein drittes Loch (30) aufweist, und
eine fünfte Substratschicht (22) mit einem vierten Loch (32),
wobei die zweite Substratschicht zwischen der ersten Substratschicht und der dritten Substratschicht angeordnet ist und fest mit diesen in Eingriff steht,
wobei das erste Loch der ersten Substratschicht und das zweite Loch der zweiten Substratschicht zueinander ausgerichtet sind, um einen ersten Hohlraum (12, 66) zu bilden, und
wobei mindestens ein erster Teil des IC-Chips in dem ersten Hohlraum aufgenommen ist,
**dadurch gekennzeichnet, dass** das Chipmodul die Form eines Prismas, eines Zylinders oder eines elliptischen Zylinders aufweist.

2. Chipmodul nach Anspruch 1, wobei die dritte Substratschicht zumindest teilweise aus Kupfer besteht.

3. Chipmodul nach Anspruch 1 oder 2, wobei die dritte Substratschicht mindestens einen Schlitz (24) aufweist, in den ein Anschlussbein (36) des IC-Chips eingreift, um den IC-Chip elektrisch mit der dritten Substratschicht zu verbinden.

4. Chipmodul nach einem der vorstehenden Ansprüche, wobei das erste Loch und das zweite Loch im Wesentlichen die gleiche Größe und Form aufweisen.

5. Chipmodul nach einem der vorstehenden Ansprüche, wobei die erste Substratschicht aus Polyimid (PI), Polyethylenterephthalat (PET) und/oder einem glasfaserverstärkten Epoxidlaminatmaterial besteht.

6. Chipmodul nach Anspruch 1, wobei das dritte Loch und das vierte Loch so zueinander ausgerichtet sind, dass sie einen zweiten Hohlraum bilden, und wobei mindestens ein zweiter Teil des IC-Chips in dem zweiten Hohlraum aufgenommen ist.

7. Chipmodul nach Anspruch 6, wobei das dritte und das vierte Loch im Wesentlichen die gleiche Größe und Form aufweisen.

8. Chipmodul nach einem der vorstehenden Ansprüche, wobei die fünfte Substratschicht aus einem elektrisch leitfähigen Material besteht oder mit einem solchen galvanisch beschichtet ist.

9. Chipmodul nach einem der vorstehenden Ansprüche, wobei zwei gegenüberliegende Hauptflächen des Chipmoduls planar, von gleicher Form und zueinander parallel sind.

10. Chipmodul-Karteneinlageelement (54), das mindestens ein Chipmodul nach einem der Ansprüche 1 bis 9 einschließt.

11. Chipmodul-Karteneinlageelement nach Anspruch 10, wobei das Chipmodul in einem fünften Loch (68) einer sechsten Substratschicht (70) aufgenommen ist.

12. Chipmodul-Karteneinlageelement nach Anspruch 11, wobei die sechste Substratschicht zwischen einer siebten Substratschicht (74) und einer achten Substratschicht (76) angeordnet ist und fest mit diesen in Eingriff steht.

13. Chipmodul-Karteneinlageelement nach einem der Ansprüche 10 bis 12, wobei das Chipmodul mit mindestens einem leitfähigen Draht (72) elektrisch verbunden ist.

14. Verfahren zur Herstellung eines Chipmoduls (40a, 40b, 62) für eine Smartcard, einschließend:
Bereitstellen einer ersten Substratschicht (18), die zumindest teilweise aus einem flexiblen Material besteht und eine Vielzahl von ersten Löchern (28) aufweist.
Bereitstellen einer zweiten Substratschicht (16), die zumindest teilweise aus einem Klebematerial besteht und eine Vielzahl von zweiten Löchern (26) aufweist.
Bereitstellen einer dritten Substratschicht (14), die zumindest teilweise aus einem elektrisch leitfähigen Material besteht,
Ausrichten der ersten Löcher der ersten Substratschicht mit den zweiten Löchern der zweiten Substratschicht, um eine Vielzahl von ersten Hohlräumen (12, 66) zu bilden,
Anordnen der zweiten Substratschicht zwischen der ersten Substratschicht und der dritten Substratschicht,
festes Ineingriffbringen der ersten Substratschicht, der zweiten Substratschicht und der dritten Substratschicht, um eine erste geschichtete Struktur (54) zu bilden,
festes Ineingriffbringen mindestens eines ersten Teils eines Chips mit integriertem Schaltkreis (IC-Chip) (34, 64) in einem der ersten Hohlräume der ersten geschichteten Struktur,
Bereitstellen einer vierten Substratschicht (20), die zumindest teilweise aus einem Klebematerial besteht und eine Vielzahl von dritten Löchern (30) aufweist, und einer fünften Substratschicht (22) mit einer Vielzahl von vierten Löchern (32),
festes Ineingriffbringen der vierten Klebesubstratschicht und der fünften Substratschicht mit der ersten geschichteten Struktur, um eine zweite geschichtete Struktur zu bilden, und
Ausschneiden mindestens eines Chipmoduls aus der zweiten geschichteten Struktur, das fest mit dem IC-Chip in Eingriff steht,
**dadurch gekennzeichnet, dass** das Chipmodul die Form eines Prismas, eines Zylinders oder eines elliptischen Zylinders aufweist.

15. Verfahren nach Anspruch 14, wobei die dritte Substratschicht zumindest teilweise aus Kupfer besteht.

16. Verfahren nach Anspruch 14 oder 15, einschließlich des Ineingriffbringens eines Anschlussbeins (36) des IC-Chips in mindestens einen Schlitz (24) der dritten Substratschicht, um den IC-Chip elektrisch mit der dritten Substratschicht zu verbinden.

17. Verfahren nach einem der Ansprüche 14 bis 16, wobei die ersten Löcher und zweiten Löcher im Wesentlichen die gleiche Größe und Form aufweisen.

18. Verfahren nach einem der Ansprüche 14 bis 17, ferner einschließend das Füllen mindestens eines Teils des Raums zwischen dem ersten Teil des IC-Chips und dem ersten Hohlraum mit einem Klebstoff.

19. Verfahren nach einem der Ansprüche 14 bis 18, wobei die erste Substratschicht aus Polyimid (PI), Polyethylenterephthalat (PET) und/oder einem glasfaserverstärkten Epoxidlaminatmaterial besteht.

20. Verfahren nach Anspruch 19, ferner einschließend das Ausrichten der dritten Löcher der vierten Klebesubstratschicht mit den vierten Löchern der fünften Substratschicht, um eine Vielzahl von zweiten Hohlräumen zu bilden, und das Positionieren mindestens eines zweiten Teils des IC-Chips in einem dieser zweiten Hohlräume.

21. Verfahren nach Anspruch 20, wobei die dritten Löcher und die vierten Löcher im Wesentlichen die gleiche Größe und Form aufweisen.

22. Verfahren nach einem der Ansprüche 20 bis 21, wobei die fünfte Substratschicht aus einem elektrisch leitfähigen Material besteht oder mit einem solchen galvanisch beschichtet ist.

23. Verfahren nach einem der Ansprüche 14 bis 22, wobei zwei gegenüberliegende Hauptflächen des Chipmoduls planar, von gleicher Form und zueinander parallel sind.

24. Verfahren zur Herstellung eines Chipmodul-Karteneinlegeelements (60), einschließend das Herstellen mindestens eines Chipmoduls gemäß einem Verfahren nach einem der Ansprüche 14 bis 23.

25. Verfahren nach Anspruch 24, einschließend das Positionieren des Chipmoduls in einem fünften Loch (68) einer sechsten Substratschicht (70).

26. Verfahren nach Anspruch 25, einschließend das Anordnen der sechsten Substratschicht zwischen einer siebten Substratschicht (74) und einer achten Substratschicht (76) und festes Ineingriffbringen der sechsten Substratschicht, der siebten Substratschicht und der achten Substratschicht miteinander.

27. Verfahren nach einem der Ansprüche 24 bis 26, einschließend das elektrischen Verbinden des Chipmoduls mit mindestens einem leitfähigen Draht (72).

## Revendications

1. Module de puce (40a, 40b, 62) pour une carte à puce incluant :
une puce de circuit intégré (IC) (34, 64),
une première couche de substrat (18) constituée au moins en partie d'un matériau flexible et comportant un premier trou (28),
une deuxième couche de substrat (16) constituée au moins en partie d'un matériau adhésif et comportant un deuxième trou (26),
une troisième couche de substrat (14) constituée au moins en partie d'un matériau électroconducteur,
une quatrième couche de substrat (20) constituée au moins en partie d'un matériau adhésif et comportant un troisième trou (30), et
une cinquième couche de substrat (22) comportant un quatrième trou (32),
dans lequel ladite deuxième couche de substrat est intercalée entre ladite première couche de substrat et ladite troisième couche de substrat et est en prise avec elles de manière permanente,
dans lequel ledit premier trou de ladite première couche de substrat et ledit deuxième trou de ladite deuxième couche de substrat sont alignés l'un sur l'autre pour former une première cavité (12, 66), et
dans lequel au moins une première partie de ladite puce d'IC est reçue dans ladite première cavité,
**caractérisé en ce que** ledit module de puce présente la forme d'un prisme, d'un cylindre ou d'un cylindre elliptique.

2. Module de puce selon la revendication 1, dans lequel ladite troisième couche de substrat est constituée au moins en partie de cuivre.

3. Module de puce selon la revendication 1 ou 2, dans lequel ladite troisième couche de substrat inclut au moins une fente (24) en prise avec une patte (36) de ladite puce d'IC pour connecter électriquement ladite puce d'IC à ladite troisième couche de substrat.

4. Module de puce selon l'une quelconque des revendications précédentes, dans lequel ledit premier trou et ledit deuxième trou sont sensiblement de même taille et de même forme.

5. Module de puce selon l'une quelconque des revendications précédentes, dans lequel ladite première couche de substrat est constituée de polyimide (PI), de polyéthylène téréphtalate (PET) et/ou d'un matériau stratifié d'époxy renforcé de fibres de verre.

6. Module de puce selon la revendication 1, dans lequel ledit troisième trou et ledit quatrième trou sont alignés l'un sur l'autre pour former une seconde cavité, et dans lequel au moins une seconde partie de ladite puce d'IC est reçue dans ladite seconde cavité.

7. Module de puce selon la revendication 6, dans lequel ledit troisième trou et ledit quatrième trou sont sensiblement de même taille et de même forme.

8. Module de puce selon l'une quelconque des revendications précédentes, dans lequel ladite cinquième couche de substrat est constituée d'un matériau électroconducteur ou recouverte de ce matériau par galvanoplastie.

9. Module de puce selon l'une quelconque des revendications précédentes, dans lequel deux surfaces principales opposées dudit module de puce sont planes, de même forme et parallèles l'une à l'autre.

10. Incrustation de carte de module de puce (54) incluant au moins un module de puce selon l'une quelconque des revendications 1 à 9.

11. Incrustation de carte de module de puce selon la revendication 10, dans laquelle ledit module de puce est reçu dans un cinquième trou (68) d'une sixième couche de substrat (70).

12. Incrustation de carte de module de puce selon la revendication 11, dans laquelle ladite sixième couche de substrat est intercalée entre une septième couche de substrat (74) et une huitième couche de substrat (76) et est en prise avec elles de manière permanente.

13. Incrustation de carte de module de puce selon l'une quelconque des revendications 10 à 12, dans laquelle ledit module de puce est connecté électriquement à au moins un fil conducteur (72).

14. Procédé de formation d'un module de puce (40a, 40b, 62) pour une carte à puce incluant :
la fourniture d'une première couche de substrat (18) constituée au moins en partie d'un matériau flexible et comportant une pluralité de premiers trous (28),
la fourniture d'une deuxième couche de substrat (16) constituée au moins en partie d'un matériau adhésif et comportant une pluralité de deuxièmes trous (26),
la fourniture d'une troisième couche de substrat (14) constituée au moins en partie d'un matériau électroconducteur,
l'alignement desdits premiers trous de ladite première couche de substrat sur lesdits deuxièmes trous de ladite deuxième couche de substrat pour former une pluralité de premières cavités (12, 66),
l'intercalation de ladite deuxième couche de substrat entre ladite première couche de substrat et ladite troisième couche de substrat,
la mise en prise de manière permanente de ladite première couche de substrat, de ladite deuxième couche de substrat et de ladite troisième couche de substrat pour former une première structure en couches (54),
la mise en prise de manière permanente d'au moins une première partie d'une puce de circuit intégré (IC) (34, 64) dans l'une desdites premières cavités de ladite première structure en couches,
la fourniture d'une quatrième couche de substrat (20) constituée au moins en partie d'un matériau adhésif et comportant une pluralité de troisièmes trous (30) et d'une cinquième couche de substrat (22) comportant une pluralité de quatrièmes trous (32),
la mise en prise de manière permanente de ladite quatrième couche de substrat adhésive et de ladite cinquième couche de substrat avec ladite première structure en couches pour former une seconde structure en couches, et
la découpe d'au moins un module de puce dans ladite seconde structure en couches mise en prise de manière permanente avec ladite puce d'IC,
**caractérisé en ce que** ledit module de puce présente la forme d'un prisme, d'un cylindre ou d'un cylindre elliptique.

15. Procédé selon la revendication 14, dans lequel ladite troisième couche de substrat est constituée au moins en partie de cuivre.

16. Procédé selon la revendication 14 ou 15, incluant la mise en prise d'une patte (36) de ladite puce d'IC avec au moins une fente (24) de ladite troisième couche de substrat pour connecter électriquement ladite puce d'IC à ladite troisième couche de substrat.

17. Procédé selon l'une quelconque des revendications 14 à 16, dans lequel lesdits premiers trous et lesdits deuxièmes trous sont sensiblement de même taille et de même forme.

18. Procédé selon l'une quelconque des revendications 14 à 17, incluant en outre le remplissage d'au moins une partie d'un espace entre ladite première partie de ladite puce d'IC et ladite première cavité avec un adhésif.

19. Procédé selon l'une quelconque des revendications 14 à 18, dans lequel ladite première couche de substrat est constituée de polyimide (PI), de polyéthylène téréphtalate (PET) et/ou d'un matériau stratifié d'époxy renforcé de fibres de verre.

20. Procédé selon la revendication 19, incluant en outre l'alignement desdits troisièmes trous de ladite quatrième couche de substrat adhésive sur lesdits quatrièmes trous de ladite cinquième couche de substrat pour former une pluralité de secondes cavités, et le positionnement d'au moins une seconde partie de ladite puce d'IC dans l'une desdites secondes cavités.

21. Procédé selon la revendication 20, dans lequel lesdits troisième trous et lesdits quatrièmes trous sont sensiblement de même taille et de même forme.

22. Procédé selon l'une quelconque des revendications 20 ou 21, dans lequel ladite cinquième couche de substrat est constituée d'un matériau électroconducteur ou recouverte de ce matériau par galvanoplastie.

23. Procédé selon l'une quelconque des revendications 14 à 22, dans lequel deux surfaces principales opposées dudit module de puce sont planes, de même forme et parallèles l'une à l'autre.

24. Procédé de formation d'une incrustation de carte de module de puce (60) incluant la formation d'au moins un module de puce conformément à un procédé selon l'une quelconque des revendications 14 à 23.

25. Procédé selon la revendication 24, incluant le positionnement dudit module de puce dans un cinquième trou (68) d'une sixième couche de substrat (70).

26. Procédé selon la revendication 25, incluant l'intercalation de ladite sixième couche de substrat entre une septième couche de substrat (74) et une huitième couche de substrat (76), et la mise en prise de manière permanente de ladite sixième couche de substrat, de ladite septième couche de substrat et de ladite huitième couche de substrat les unes avec les autres.

27. Procédé selon l'une quelconque des revendications 24 à 26, incluant la connexion électrique dudit module de puce à au moins un fil conducteur (72).
